# EUROPEAN PATENT SPECIFICATION

(11) **EP 4 270 490 B1**
(45) Date of publication and mention of the grant of the patent: **24.09.2025**
(21) Application number: 23741247.3
(22) Date of filing: 20.03.2023
(51) Int. Cl.: H10D 12/01, H10D 30/66, H10D 62/17, H10D 62/832, H10D 62/834

(54) **MOSFET DEVICE AND MANUFACTURING METHOD THEREFOR**
MOSFET-BAUELEMENT UND HERSTELLUNGSVERFAHREN DAFÜR
DISPOSITIF MOSFET ET SON PROCÉDÉ DE FABRICATION

(30) Priority: 24.10.2022 CN 202211305002
(43) Date of publication of application: 01.11.2023
(73) Proprietor: United Nova Technology - Yuezhou (Shaoxing) Corp., Shaoxing, Zhejiang 312000 (CN)
(72) Inventor: LI, Xiang, Shaoxing Zhejiang 312000 (CN); XIE, Zhiping, Shaoxing Zhejiang 312000 (CN); CONG, Maojie, Shaoxing Zhejiang 312000 (CN); LIANG, Xinying, Shaoxing Zhejiang 312000 (CN); ZHANG, Yukai, Shaoxing Zhejiang 312000 (CN)
(74) Representative: Kraus & Lederer PartGmbB
(86) International application number: PCT/CN2023/082486
(87) International publication number: WO 2023/169592

(56) References cited:
- CN-A- 108 352 407
- CN-A- 112 701 151
- CN-A- 112 701 151
- CN-A- 115 458 604
- JP-A- 2000 082 812
- US-A1- 2003 201 503
- US-A1- 2009 008 650
- US-A1- 2017 084 700
- US-A1- 2017 084 700
- US-A1- 2018 323 299
- US-B1- 7 170 084

## Description

### TECHNICAL FIELD

The present invention relates to the field of the manufacturing technology of MOSFET devices, in particular to a metal oxide semiconductor field effect transistor (MOSFET) device and a manufacturing method therefor.

### BACKGROUND

Silicon carbide (SiC) metal oxide semiconductor field effect transistor (MOSFET) devices have the advantages of high switching speed, low conduction resistance, and the like, can achieve a higher breakdown voltage level with a smaller drift layer thickness, can reduce the volume of power switch modules and reduce the energy consumption, and have obvious advantages in application fields such as power switches and converters.

Due to the weak diffusion of Al (aluminum) ion implantation in SiC, in an existing planar gate SiC MOSFET process, a certain depth of P well is usually obtained by multiple Al ion implantation first, and then, an N+source region, a P+bulk region (also known as a P+contact region), and the like are formed in the P well by ion implantation.

However, multiple Al ion implantation breaks the SiC surface at the planar gate SiC MOSFET channel, which leads to the roughness of the surface of the P well channel, increases the channel scattering, and limits the increase of the channel carrier mobility.

The above problems also exist in other planar MOSFET processes that use multiple Al ion implantation to form P wells.

Devices and manufacturing method according to the state of the art are known from US 2003/201503 A1, US 2018/323299 A1, US 2009/008650 A1, and US 7 170 048 B1.

### SUMMARY

The objective of the present invention is to provide a MOSFET device and a manufacturing method therefor, which can avoid the damage to the surface of a P-well channel by ion implantation to achieve high conductivity of the device.

In order to achieve the above objective, the present invention provides a manufacturing method of a MOSFET device, including the steps in claim 1. Further embodiments are claimed in the dependent claims.

Compared with the prior art, the technical solution of the present invention at least has one of the following beneficial effects:
1. First, a first implantation region easy to diffuse is formed, and then, a second implantation region which is not easy to diffuse and has a deeper junction is formed in sequence. After ion implantation in a source region and the like is completed, the first implantation region is activated to form a required well region in a mode of junction diffusion in the first implantation region, and the second implantation region is used for increasing the depth of the well region, thereby avoiding the problems of damage to the surface of a substrate at a channel caused by the formation of a P well directly through multiple Al ion implantation in the prior art, which leads to the roughness of the surface of the channel of the device, and achieves high conductivity of the device.
2. The ion implantation in the first implantation region, the second implantation region and the source region can use a same mask layer, so that the process is simple to implement, and the photoetching frequency can be effectively reduced.

### BRIEF DESCRIPTION OF THE DRAWINGS

Those skilled in the art will understand that the accompanying drawings are provided for better understanding the present invention without any limitation on the scope of the present invention, which is only defined by the appended claims.
FIG. 1 shows a schematic flowchart illustrating a manufacturing method of a MOSFET device according to an embodiment of the present invention.
FIG. 2 shows cross-sectional schematic views illustrating device structures in the manufacturing method of the MOSFET device shown in FIG. 1.

### DETAILED DESCRIPTION

In the following description, a lot of specific details are given in order to provide a more thorough understanding of the present invention. However, it is obvious to those skilled in the art that the present invention may be implemented without one or more of these details. In other examples, in order to avoid confusion with the present invention, some technical features known in the art are not described. It should be understood that the present invention may be implemented in different forms and should not be limited to the embodiments provided here. On the contrary, the embodiments are provided to make the disclosure more thorough and complete, and fully convey the scope of the present invention to those skilled in the art. The scope of the present invention is, however, only defined by the present claims. In the accompanying drawings, the sizes of layers and regions and the relative sizes may be exaggerated for clarity. Throughout the specification, same reference numerals represent same components. It should be understood that when a component or layer is referred to as being "on" or "connected to" another component or layer, the component may be directly on the another component or layer or connected to the another component or layer, or there may be an intervening component or layer. On the contrary, when a component is referred to as being "directly on" or "directly connected to" another component or layer, there is no intervening component or layer. Although terms such as "first" and "second" may be used for describing various components, elements, regions, layers and/or parts, the components, elements, regions, layers, and/or parts should not be limited by the terms. The terms are only used for distinguishing one component, element, region, layer or part from another component, element, region, layer or part. Therefore, without departing from the instruction of the present invention, a first component, element, region, layer or part discussed below may be represented as a second component, element, region, layer or part. Spatial relationship terms such as "below", "under", "lower", "above", "on" and "upper" can be used here for convenience of describing the relationship between a component or feature shown in the figure and another component or feature. It should be understood that in addition to the orientations shown in the figure, the spatial relationship terms are also intended to include different orientations of devices in use and operation. For example, if a device in the figure is turned, the component or feature described as "below", "under" or "being on the lower part" will be oriented as being "above" another component or feature. The device may be oriented by rotating 90 degrees or in other orientations, and the spatial description terms used here are explained accordingly. The terms are only used for describing specific embodiments here and are not intended to limit the present invention. Singular forms including "a", "an" and "the/this" used here may also be intended to include plural forms, unless the context clearly indicates another mode. It should also be understood that the term "include" is used for determining the presence of features, steps, operations, components and/or elements, but does not exclude the presence or addition of one or more other features, steps, operations, components, elements and/or groups. The term "and/or" used here includes any or all combinations of related listed items.

The technical solution provided by the present invention is further described in detail below with reference to the accompanying drawings and specific embodiments. According to the following descriptions, the advantages and features of the present invention will be clearer. It should be noted that the accompanying drawings are drawn in an extremely simplified form and imprecise proportion, which are only used for conveniently and clearly assisting in describing the objectives of the embodiments of the present invention.

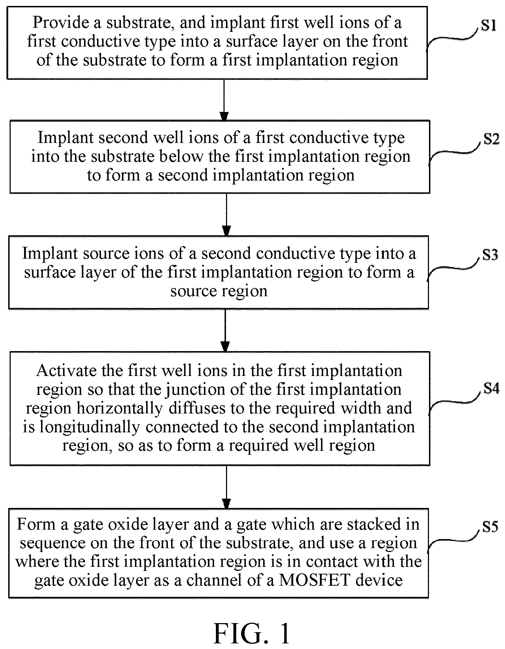

Referring to FIG. 1, an embodiment of the present invention provides a manufacturing method of a MOSFET device, including the following steps:
S1: a substrate is provided, and first well ions of a first conductive type (such as a P type) are implanted in a surface layer on the front of the substrate to form a first implantation region;
S2: second well ions of the first conductive type are implanted in the substrate below the first implantation region to form a second implantation region;
S3: source ions of a second conductive type (such as an N type) are implanted in a surface layer of the first implantation region to form a source region;
S4: the first well ions in the first implantation region are activated so that the junction of the first implantation region horizontally diffuses to the required width and is longitudinally connected to the second implantation region, so as to form a required well region; and
S5: a gate oxide layer and a gate which are stacked in sequence are formed on the front of the substrate, and a region where the first implantation region is in contact with the gate oxide layer is used as a channel of the MOSFET device.

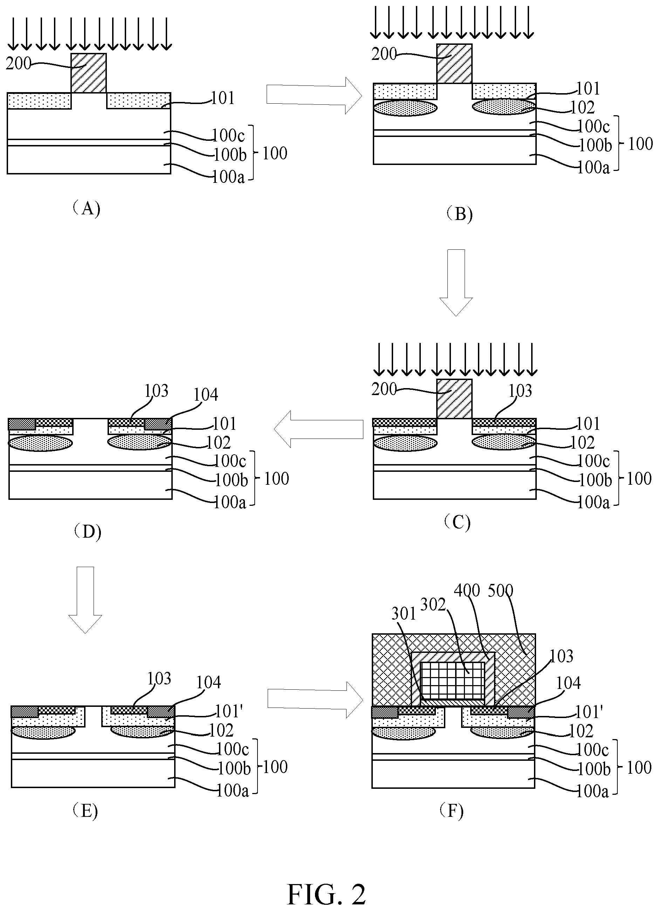

Referring to FIG. 2(A), in step S1, any appropriate semiconductor material such as silicon carbide (SiC) or silicon may be provided to form a substrate 100. For example, the provided substrate 100 is an N type SiC substrate with three layers from bottom to top, namely an N+substrate 100a, a buffer layer 100b and an N-drift layer 100c in sequence. The doping concentration of N type ions in the N-drift layer 100c is lower than the doping concentration of N type ions in the N+substrate 100a.

Specifically, referring to FIG. 2(A), in step S1, first, the surface of the substrate 100 may be cleaned and dried; and then, a mask layer material is deposited on the N-drift layer 100c, the mask layer material may be selected from one or more of polysilicon (poly Si), single crystal silicon (Si), silicon dioxide (SiO₂), silicon nitride (SiN) and the like, the mask layer material may be a single layer film or may be formed by superposition of films of multiple different materials, and the mask layer material is subjected to photoetching and etching to form a patterned mask layer 200 for defining the P well to be formed. In this example, implantation windows (not shown) for the P well to be formed are defined on both sides of the patterned mask layer 200; and then, the patterned mask layer 200 is used as a mask, and first well ions of P type are implanted into a surface layer of the N-drift layer 100c to form a first implantation region 101 in the surface layer of the N-drift layer 100c on both sides of the patterned mask layer 200. The first well ions used in this step are ions that may form a cavity in the N-drift layer 100c and are easier to diffuse at a high temperature compared to subsequent second well ions and source ions. As an example, the first well ions are boron ions or boron fluoride ions, the implantation direction may be perpendicular to the surface of the N-drift layer 100c, the implantation energy is 50-300 keV (such as 100 keV, or 200 keV), and the implantation dose is 1E11/cm²-6E14/cm² (such as 5E12/cm², or 1E13/cm²).

Referring to FIG. 2(B), in step S2, the patterned mask layer 200 is used as a mask, and second well ions of P type are implanted in the N-drift layer 100c below the first implantation region 101 to form a second implantation region 102 in the N-drift layer 100c below the first implantation region 101 on both sides of the patterned mask layer 200. Therefore, the second implantation region 102 may form a deeper junction than the first implantation region 101. As an example, ions may be vertically or obliquely implanted in the N-drift layer 100c below the first implantation region 101 through multiple aluminum (Al) ion implantation according to the depth and width requirements for P well design. The implantation temperature is 400-1000°C (such as 500°C, or 800°C), the implantation energy is 200-500 keV (such as 300 keV, or 400 keV), and the implantation dose is 1E11/cm²-6E14/cm² (such as 5E12/cm², 1E13/cm², or 1E14/cm²).

Referring to FIG. 2(C), in step S3, the patterned mask layer 200 is used as a mask, and N type source ions are vertically or obliquely implantation in the surface layer of the first implantation region 101 according to the depth and width requirements for source region design, so as to form a source region 103 in the surface layer of the first implantation region 101 on both sides of the patterned mask layer 200. As an example, N type source ions include at least one of phosphorus (P) ions, arsenic (As) ions, nitrogen (N) ions and the like, the implantation energy is 50-300 keV (such as 100 keV, or 200 keV), and the implantation dose is 1E14/cm²-1E16/cm² (such as 5E14/cm², 1E15/cm², or 5E15/cm²).

Referring to FIG. 2(D), in step S3, optionally, after the source region 103 is formed, the patterned mask layer 200 is removed, bulk ions of P type are implantation in a portion of the source region 103 to form a bulk region 104 (also known as a contact region), the bottom of the bulk region 104 penetrates into a portion of the first implantation region 101 to short-circuit the source region 103 and the first implantation region 101, and the doping concentration of the P type ions is higher than that in the first implantation region 101. As an example, the bulk ions may include at least one of boron ions, boron fluoride ions and aluminum ions, the implantation energy is 50-300 keV (such as 100 keV, or 200 keV), and the implantation dose is 1E14/cm²-1E16/cm² (such as 5E14/cm², 1E15/cm², or 5E15/cm²).

Referring to FIG. 2(E), in step S4, the substrate 100 is annealed by a high-temperature annealing process to activate the first well ions in the first implantation region 101, and also activate the second well ions in the second implantation region 102, and the P type ions of the N-type ion bulk region 104 in the source region 103. The annealing temperature is 1500-1900°C (such as 1650°C, 1700°C, or 1800°C), and the annealing time is 2-200 min (such as 10 min, 20 min, 50 min, or 100 min). The high-temperature annealing process causes diffusion of first well ions such as boron ions in the first implantation region 101, the bottom of the first implantation region 101' after diffusion is longitudinally connected to the top of the second implantation region 102, and the first implantation region after diffusion horizontally extends to a required width of the P well to provide a required channel width subsequently. Moreover, the diffusion of the second well ions in the second implantation region 102, and the P type ions of the N-type ion bulk region 104 in the source region 103 is relatively weak compared to the first well ions in the first implantation region 101, and the N-drift layer 101c between the two first implantation regions 101' after diffusion is used as a depletion region.

In this step, the required well region is composed of the first implantation region 101' at the upper part after diffusion and the second implantation region 102 at the lower part. Moreover, since the required channel is formed by diffusion of the first implantation region 101, the roughness of the surface of the channel can be greatly reduced. As a result, the interface scattering of channel electrons in the finally manufactured MOSFET device can be reduced, thereby increasing the channel mobility.

Referring to FIG. 2(F), in step S5, first, an appropriate gate oxidation process such as a thermal oxidation process or a chemical vapor deposition process may be used for forming a gate oxide layer 301 on the front of the bulk region 104, the source region 103, the first implantation region 101' after diffusion and the N-drift layer 100c; and then, a gate material layer may be deposited on the surface of the gate oxide layer 301, and the deposited gate material layer and the gate oxide layer 301 are subjected to photoetching and etching to form a gate 302. The formed gate 302 is overlapped with both the first implantation region 101' after diffusion and the source region 104, and a region where the first implantation region 101' after diffusion is in contact with the gate oxide layer 301 is used as a channel of the MOSFET device.

In this step, since the P well is formed in a mode of diffusion in step S4, the roughness of the surface of the channel can be effectively avoided, and the SiC crystal quality of the N-drift layer 100c used as a depletion region can be ensured to be intact. As a result, the quality of the formed gate oxide layer 301 can be ensured, and the defect density of the channel can be reduced, thereby further improving the temperature drift performance of the device and further enhancing the reliability of the device.

Further optionally, after the gate 302 is formed, first, the front of the substrate 100 is covered with an interlayer dielectric layer 400 by a chemical vapor deposition process and the like. The interlayer dielectric layer 400 may be a single-layer dielectric film structure or a structure formed by stacking multiple layers of dielectric films. Then, the interlayer dielectric layer 400 is subjected to photoetching and etching to pattern the interlayer dielectric layer 400, and the patterned interlayer dielectric layer 400 may bury the gate 302 inside and expose a portion of the source region 103. Then, a source metal layer 500 (such as a metal material or alloy of copper, aluminum, gold, and the like) is formed on the interlayer dielectric layer 400 by an appropriate process such as metal sputtering deposition or vapor deposition. The source metal layer 500 is electrically connected to both the source region 103 and the bulk region 104. Then, a drain metal layer (not shown) is formed on the back of the N+substrate 100a.

According to the manufacturing method of the MOSFET device in this embodiment, the required well region is formed in a mode of diffusion. On one hand, the roughness of the surface of the channel can be greatly reduced, and the interface scattering of channel electrons can be reduced, thereby increasing the channel mobility. On the other hand, the defect level of the channel and the quality of the gate oxide layer can be improved, thereby further improving the temperature drift performance of the device and further enhancing the reliability of the device.

In addition, the ion implantation in the first implantation region, the second implantation region and the source region can be implemented by the same patterned mask layer 200, so that the process is simple to implement, and the photoetching frequency can be effectively reduced.

Referring to FIG. 2(F), shows a MOSFET device which is manufactured by the manufacturing method of the MOSFET device of the present invention. The MOSFET device includes:
a substrate 100, where the substrate 100 may be any appropriate semiconductor material, for example, the substrate 100 may be an N type SiC substrate with three layers from bottom to top, namely an N+substrate 100a, a buffer layer 100b and an N-drift layer 100c in sequence;
a first conductive type (such as a P type) of well region, including a first implantation region 101 and a second implantation region 102 which are formed from top to bottom, where the first implantation region 101 is formed in a surface layer of a portion of the region on the front of the N-drift layer 100c, the second implantation region 102 is formed in the N-drift layer 100c below the bottom of the first implantation region 101, the first implantation region 101 longitudinally diffuses to be connected to the second implantation region 102, ions of the first conductive type doped in the first implantation region 101 include boron ions or boron fluoride ions, and ions of the first conductive type doped in the second implantation region 102 include aluminum ions;
a source region 103 formed on a surface layer of the first implantation region 101; and
a gate oxide layer 301 and a gate 302 which are stacked on the front of the N-drift layer 100c in sequence, where the gate 302 is overlapped with both the first implantation region 103 and the source region 104, and the first implantation region 103 horizontally extends further compared to the second implantation region 102 at the bottom of the gate 302.

In conclusion, according to the MOSFET manufacturing method of the present invention, first, a first implantation region easy to diffuse is formed, and then, a second implantation region which is not easy to diffuse and has a deeper junction is formed in sequence. After ion implantation in a source region and the like is completed, the first implantation region is activated to form a required well region in a mode of junction diffusion in the first implantation region, and the second implantation region is used for increasing the depth of the well region, thereby avoiding the problems of damage to the surface of a substrate at a channel and roughness of the surface of the channel of the device caused by the formation of a P well directly through multiple Al ion implantation in the prior art, and achieving high conductivity of the device. In addition, the ion implantation in the first implantation region, the second implantation region and the source region can use a same mask layer, so that the process is simple to implement, and the photoetching frequency can be effectively reduced.

The above description is only a description of the preferred embodiments of the present invention and does not limit the scope of the present invention. The scope of the present invention is only defined by the subject matter of the appended claims.

Any changes or modifications made by those skilled in the art of the present invention according to the above disclosed contents belong to the protection scope of the technical solution of the present invention, as long as such changes and/or modifications fall under the scope of the independent claim.

## Claims

1. A manufacturing method of a metal oxide semiconductor field effect transistor (MOSFET) device, comprising:
providing a substrate (100), forming a patterned mask layer (200) for defining a well region on the front of the substrate (100) and using the patterned mask layer (200) as a mask, and implanting first well ions of a first conductive type into a surface layer on the front of the substrate (100) to form a first implantation region (101);
using the patterned mask layer (200) as the mask, implanting second well ions of the first conductive type into the substrate (100) below the first implantation region (101) to form a second implantation region (102);
using the patterned mask layer (200) as the mask, implanting source ions of a second conductive type into a surface layer of the first implantation region (101) to form a source region (103);
removing the patterned mask layer (200), and annealing the substrate (100) by a high-temperature annealing process to activate the first well ions in the first implantation region (101) so that the first implantation region (101) is longitudinally connected to the second implantation region (102) and horizontally extends to a required width to provide a required channel width subsequently, so as to form a required well region; and
forming a gate oxide layer (301) and a gate (302) which are stacked in sequence on the front of the substrate (100), and using a region where the first implantation region (101) is in contact with the gate oxide layer (301) as a channel of the MOSFET device; and
forming a drain metal layer on a back of the substrate (100), **characterized in that**:
in the process of activating the first well ions in the first implantation region (101), the diffusion of the second well ions in the second implantation region (102), and the source ions in the source region (103) is relatively weak compared to the first well ions in the first implantation region (101), the channel of the MOSFET device is formed by diffusion of the first implantation region (101).

2. The manufacturing method according to claim 1, wherein after removing the patterned mask layer (200) and before activating the first well ions in the first implantation region (101), the manufacturing method further comprises:
using another mask, implanting bulk ions of the first conductive type in a portion of the source region (103) to form a bulk region (104), and enabling the bulk region (104) to penetrate into a portion of the first implantation region (101) to short-circuit the source region (103) and the first implantation region (101).

3. The manufacturing method according to claim 1, wherein the first well ions comprise boron ions or boron fluoride ions; and the second well ions comprise aluminum ions.

4. The manufacturing method according to claim 3, wherein implantation process parameters of the first well ions are as follows: the implantation energy is 50-300 keV, and the implantation dose is 1E11/cm²-6E14/cm².

5. The manufacturing method according to claim 3, wherein the first well ions in the first implantation region (101) are activated by an annealing process, the annealing temperature is 1500-1900°C, and the annealing time is 2-200 min.

6. The manufacturing method according to claim 3, wherein the substrate (100) comprises a silicon carbide layer of the second conductive type, and both the first implantation region (101) and the second implantation region (102) are formed in the SiC layer.

7. The manufacturing method according to any one of claims 1 to 6, further comprising:
forming an interlayer dielectric layer (400) on the front of the substrate (100), the interlayer dielectric layer (400) burying the gate (302) inside and exposing a portion of the source region (103); and
forming a source metal layer (500) on the interlayer dielectric layer (400), the source metal layer (500) being electrically connected to the source region (103).

## Patentansprüche

1. Herstellungsverfahren für eine Metall-Oxid-Halbleiter-Feldeffekttransistor (MOSFET)-Vorrichtung, umfassend:
Bereitstellen eines Substrats (100), Bilden einer gemusterten Maskenschicht (200) zum Definieren eines Wannenbereichs auf der Vorderseite des Substrats (100) und Verwenden der gemusterten Maskenschicht (200) als eine Maske, und Implantieren von Ionen einer ersten Wanne eines ersten Leitfähigkeitstyps in eine Oberflächenschicht auf der Vorderseite des Substrats (100), um einen ersten Implantationsbereich (101) zu bilden;
Verwenden der gemusterten Maskenschicht (200) als die Maske, Implantieren von Ionen einer zweiten Wanne des ersten Leitfähigkeitstyps in das Substrat (100) unterhalb des ersten Implantationsbereichs (101), um einen zweiten Implantationsbereich (102) zu bilden;
Verwenden der gemusterten Maskenschicht (200) als die Maske, Implantieren von Source-Ionen eines zweiten Leitfähigkeitstyps in eine Oberflächenschicht des ersten Implantationsbereichs (101), um einen Sourcebereich (103) zu bilden;
Entfernen der gemusterten Maskenschicht (200) und Glühen des Substrats (100) durch einen Hochtemperatur-Glühprozess, um die Ionen der ersten Wanne in dem ersten Implantationsbereich (101) zu aktivieren, so dass der erste Implantationsbereich (101) longitudinal mit dem zweiten Implantationsbereich (102) verbunden ist und sich horizontal bis zu einer erforderlichen Breite erstreckt, um anschließend eine erforderliche Kanalbreite bereitzustellen, damit ein erforderlicher Wannenbereich gebildet wird; und
Bilden einer Gateoxidschicht (301) und eines Gates (302), die sequenziell auf der Vorderseite des Substrats (100) gestapelt sind, und Verwenden eines Bereichs, in dem der erste Implantationsbereich (101) in Kontakt mit der Gate-Oxidschicht (301) steht, als einen Kanal der MOSFET-Vorrichtung; und
Bilden einer Drain-Metallschicht auf einer Rückseite des Substrats (100), **dadurch gekennzeichnet, dass**:
in dem Prozess des Aktivierens der Ionen der ersten Wanne in dem ersten Implantationsbereich (101), im Vergleich zu den Ionen der ersten Wanne in dem ersten Implantationsbereich (101), die Diffusion der Ionen der zweiten Wanne in dem zweiten Implantationsbereich (102) und der Source-Ionen in dem Sourcebereich (103) relativ schwach ist, wobei der Kanal der MOSFET-Vorrichtung durch Diffusion des ersten Implantationsbereichs (101) gebildet wird.

2. Herstellungsverfahren nach Anspruch 1, wobei das Herstellungsverfahren nach dem Entfernen der gemusterten Maskenschicht (200) und vor dem Aktivieren der Ionen der ersten Wanne im ersten Implantationsbereich (101) ferner Folgendes umfasst:
Verwenden einer weiteren Maske, Implantieren von Bulk-Ionen des ersten Leitfähigkeitstyps in einen Teil des Sourcebereichs (103), um einen Bulkbereich (104) zu bilden, und Ermöglichen des Eindringens des Bulkbereichs (104) in einen Teil des ersten Implantationsbereichs (101), um den Sourcebereich (103) und den ersten Implantationsbereich (101) kurzzuschließen.

3. Herstellungsverfahren nach Anspruch 1, wobei die Ionen der ersten Wanne Borionen oder Borfluoridionen und die Ionen der zweiten Wanne Aluminiumionen umfassen.

4. Herstellungsverfahren nach Anspruch 3, wobei die Implantationsprozessparameter der Ionen der ersten Wanne wie folgt sind: die Implantationsenergie 50-300 keV und die Implantationsdosis 1E11/cm²-6E14/cm² beträgt.

5. Herstellungsverfahren nach Anspruch 3, wobei die Ionen der ersten Wanne im ersten Implantationsbereich (101) durch einen Glühprozess aktiviert werden, wobei die Glühtemperatur 1500-1900°C und die Glühzeit 2-200 min beträgt.

6. Herstellungsverfahren nach Anspruch 3, wobei das Substrat (100) eine Siliziumcarbidschicht des zweiten Leitfähigkeitstyps umfasst und sowohl der erste Implantationsbereich (101) als auch der zweite Implantationsbereich (102) in der SiC-Schicht gebildet sind.

7. Herstellungsverfahren nach einem der Ansprüche 1 bis 6, ferner umfassend:
Bilden einer dielektrischen Zwischenschicht (400) auf der Vorderseite des Substrats (100), welche dielektrische Zwischenschicht (400) das Gate (302) im Inneren begräbt und einen Teil des Sourcebereichs (103) freilegt; und
Bilden einer Source-Metallschicht (500) auf der dielektrischen Zwischenschicht (400), welche Source-Metallschicht (500) elektrisch mit dem Sourcebereich (103) verbunden ist.

## Revendications

1. Procédé de fabrication d'un dispositif de transistor à effet de champ de semi-conducteur à oxyde métallique (MOSFET), comprenant :
fournir un substrat (100), former une couche de masque à motifs (200) pour définir une région de puits sur le front du substrat (100) et utiliser la couche de masque à motifs (200) comme masque, et implanter des premiers ions de puits d'un premier type conducteur à l'intérieur d'une couche de surface sur le front du substrat (100) pour former une première région d'implantation (101) ;
utiliser la couche de masque à motifs (200) comme masque, implanter des seconds ions de puits du premier type conducteur à l'intérieur du substrat (100) sous la première région d'implantation (101) pour former une seconde région d'implantation (102) ;
utiliser la couche de masque à motifs (200) comme masque, implanter des ions de source d'un second type conducteur à l'intérieur d'une couche de surface de la première région d'implantation (101) pour former une région de source (103) ;
éliminer la couche de masque à motifs (200) et recuire le substrat (100) par un procédé de recuit à haute température pour activer les premiers ions de puits dans la première région d'implantation (101) de sorte que la première région d'implantation (101) soit reliée longitudinalement à la seconde région d'implantation (102) et s'étende horizontalement jusqu'à une largeur requise pour fournir ultérieurement une largeur de canal requise, formant ainsi une région de puits requise ; et
former une couche d'oxyde de grille (301) et une grille (302) qui sont empilées par séquence sur le front du substrat (100), et utiliser une région où la première région d'implantation (101) est en contact avec la couche d'oxyde de grille (301) comme canal du dispositif MOSFET ; et
former une couche métallique de drain sur un dos du substrat (100), **caractérisé en ce que**
dans le processus d'activation des premiers ions de puits dans la première région d'implantation (101), la diffusion des seconds ions de puits dans la seconde région d'implantation (102) et des ions de source dans la région de source (103) est relativement faible par rapport aux premiers ions de puits dans la première région d'implantation (101), et le canal du dispositif MOSFET est formé par diffusion de la première région d'implantation (101).

2. Procédé de fabrication selon la revendication 1, dans lequel, après l'élimination de la couche de masque à motifs (200) et avant l'activation des premiers ions de puits dans la première région d'implantation (101), le procédé de fabrication comprend en outre :
utiliser un autre masque, implanter des ions en vrac du premier type conducteur dans une partie de la région de source (103) pour former une région en vrac (104), et permettre la région en vrac (104) de pénétrer dans une partie de la première région d'implantation (101) pour court-circuiter la région de source (103) et la première région d'implantation (101).

3. Procédé de fabrication selon la revendication 1, dans lequel les premiers ions de puits comprennent des ions bore ou des ions fluorure de bore ; et les seconds ions de puits comprennent des ions aluminium.

4. Procédé de fabrication selon la revendication 3, dans lequel des paramètres du processus d'implantation des premiers ions de puits sont les suivants : l'énergie d'implantation est de 50 à 300 keV et la dose d'implantation est de 1E11/cm²-6E14/cm².

5. Procédé de fabrication selon la revendication 3, dans lequel les premiers ions de puits dans la première région d'implantation (101) sont activés par un processus de recuit, la température de recuit est de 1500 à 1900°C et le temps de recuit est de 2 à 200 min.

6. Procédé de fabrication selon la revendication 3, dans lequel le substrat (100) comprend une couche de carbure de silicium du second type conducteur, et la première région d'implantation (101) et la seconde région d'implantation (102) sont formées dans la couche de SiC.

7. Procédé de fabrication selon l'une quelconque des revendications 1 à 6, comprenant en outre :
former une couche diélectrique intercouche (400) sur le front du substrat (100), la couche diélectrique intercouche (400) enterrant la grille (302) à l'intérieur et exposant une partie de la région de source (103) ; et
former une couche métallique de source (500) sur la couche diélectrique intercalaire (400), la couche métallique de source (500) étant connectée électriquement à la région de source (103).
